# EUROPEAN PATENT SPECIFICATION

(11) **EP 4 399 737 B1**
(45) Date of publication and mention of the grant of the patent: **03.06.2026**
(21) Application number: 22884437.9
(22) Date of filing: 19.10.2022
(51) Int. Cl.: A46B 13/00, A46D 1/00, B08B 1/12, B08B 1/34, H10P 72/00

(54) **POST CMP BRUSH AND METHOD OF MANUFACTURE**
POST-CMP-BÜRSTE UND HERSTELLUNGSVERFAHREN
BROSSE DE NETTOYAGE POST-CMP ET SON PROCÉDÉ DE FABRICATION

(30) Priority: 23.10.2021 US 202163271130 P; 10.12.2021 US 202163288472 P
(43) Date of publication of application: 17.07.2024
(73) Proprietor: Illinois Tool Works Inc., Glenview, IL 60025 (US)
(72) Inventor: BAJAJ, Rajeev, San Jose, CA 95127 (US)
(74) Representative: HGF
(86) International application number: PCT/US2022/047187
(87) International publication number: WO 2023/069557

(56) References cited:
- KR-A- 20070 103 955
- US-A1- 2006 276 108
- US-A1- 2011 277 789
- US-A1- 2016 229 653
- US-A1- 2016 229 653
- US-B1- 6 616 516
- US-B2- 6 971 950
- US-B2- 8 408 977

## Description

### CROSS REFERENCE TO RELATED APPLICATIONS

This application claims priority from provisional patent application serial number 63/271,130 filed on October 23, 2021 and provisional patent application serial number 63/288,472 filed on December 10, 2021 with the US Patent Office.

### BACKGROUND

Various exemplary embodiments of the present invention relate generally to post CMP (Chemical Mechanical polishing) wafer cleaning and, more particularly, to an engineered post CMP brush for reduced DIW (Deionized water) usage.

Semiconductor fabrication processes require significant water use. Currently, each advanced node, completed 200 mm equivalent wafer uses approximately 1300 gallons of water. See "Intel Corporate Responsibility Report 2020-21." Based on the total worldwide semiconductor capacity of approximately 135 million wafers (200 mm equivalent) the water usage is approximately 175 billion gallons of water per year. See https://www.eenewseurope.com/news/top-five-chip-makers-dominate-global-wafer-capacity.

As semiconductor usage continues to grow, water usage in semiconductor fabrication will cause strain on total available natural water resources and its availability for other purposes. Overall water usage needs to be reduced for efficient resource utilization in alignment with current Global 1.5 °C climate goals.

One important element to reducing water usage is to address the water usage at the source by designing more efficient processes. Chemical Mechanical Polishing (CMP) process is one of the key processes in semiconductor wafer processing and is water intensive. A leading chip using a 10nm process may need to revisit dielectric and metal CMP steps in total for more than 20 times for fabricating the device. Wafers are polished by pressing against a polyurethane pad while applying a slurry composed of metal oxide nanoparticles along with chemicals to affect removal with smooth finish. Wafers are then cleaned in the integrated Post CMP (PCMP) cleaner using PVA brushes which have water flowing through the brushes. See "Process Consistency in Post-CMP Cleaning: Challenges and Opportunities" Singh, Rakesh K, et. al.

Additionally, water and cleaning chemicals are sprayed onto the wafers to aid removal of particles and debris. PVA brushes are highly porous network of crosslinked polyvinyl acetate (PVA) with pore size in the range of 30 - 100 µm depending on the manufacturer and the type of brush being used. Porosity may range from 80-90%. Cleaning is accomplished by pressing a rotating, water filled, brush against a rotating wafer.

A typical PCMP cleaner for 300mm wafers has two brush stations each containing two brushes. The wafer is cleaned by placing it between the two brushes. The water flow rate in each brush is approximately 0.5 liters per minute, so the PCMP cleaner requires continuous 2 liters per minute, while additional spray nozzles are on during wafer cleaning. Spray nozzles use additional water, up to 2 liters per minute. The PCMP cleaner therefore uses 2 liters per minute continuous and up to 4 liters per minute during wafer cleaning. This translates to up to 1 million liters per cleaner per year (280K gallons) in standby mode or 2 million liters/year (560k gallons) in 100% cleaning mode. A more DIW efficient process or cleaner is therefore very desirable.

In existing brush designs, a microporous PVA (polyvinyl alcohol) brush is used. Water flow rate required to get uniform flow through the brush is a function of the pore percentage and the pore size. Higher pore percentage generally requires higher flow. Also, larger pore size generally requires higher flow. Similarly brush compressibility is also proportional to pore size and pore percentage. Current brush design, therefore, has strong coupling between pore percentage, pore size and compressibility to affect wafer surface cleaning. Reduction in pore percentage can help reduce water flow but also reduces compressibility affecting cleaning efficiency. Additionally for conventional brush cleaning surface contact is also controlled by pores. DIW flow thru the brush and DIW sprayed onto the brush-wafer during cleaning need to be optimized for cleaning. In conventional designs, the DIW flow through the brush needs to be adequate or sufficiently large to eliminate the risk of back diffusion of debris into the brush. This is an important consideration which leads in high DIW usage.

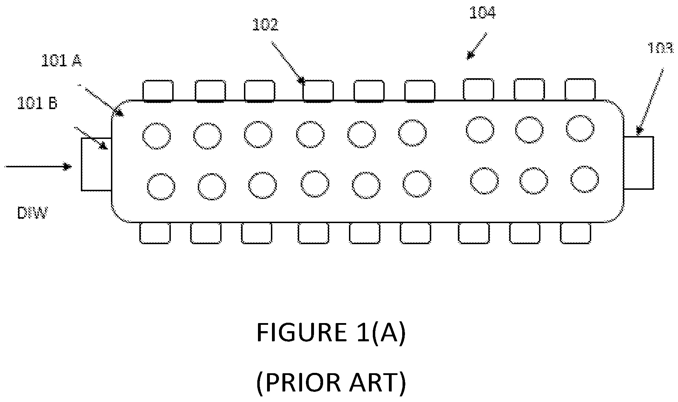

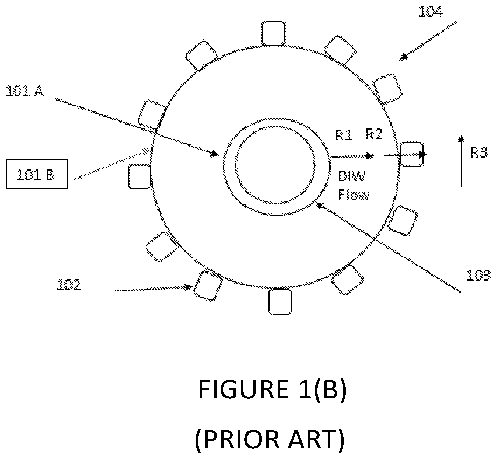

FIG. 1(a) is a simplified schematic of a conventional brush and Fig 1(b) shows the cross section of the same. PVA Brush core [101] is mounted on the mandrel [103] through which DIW flows thru the brush. Brush nodules [102] contact the wafer during cleaning. Additional DIW [104] is sprayed onto the brush during cleaning.

U.S. Pat. No. 4,098,728, describes a polyvinyl acetal sponge and a method for making the same. In this method, pore spaces in the sponge are formed by gas bubbles; rather than pore forming chemical additives such as starch/sulfate combinations. Because the sponge disclosed in this patent does not have any starch residue, it has been particularly useful in medical applications in which starch residues can cause a foreign body reaction when in contact with human tissue.

The use of synthetic sponges, made of polyvinyl acetal or cleaning devices is well known. For example, U.S. Pat. No. 4,566,911 discloses a roller scrubbing device using a polyvinyl acetal material for cleaning semiconductor chips having a surface layer of elastic polyvinyl acetal material with an average pore diameter ranging from 10 to 200 microns. If the average pore opening is less than 10 µm, the porous elastic material may have poor elasticity, thus making the performance of the cleaning roll unsatisfactory. If the average pore opening is more than 200 µm, the porous elastic material becomes unsuitable for the cleaning roll because of the bastard pore configuration. If the 30% compression stress is less than 15 g/cm², the porous elastic material is too soft, thus developing strain by the rotation of the cleaning roll. If the 30% compression stress is more than 150 g/cm², the porous elastic material is too rigid, resulting in poor elasticity.

U.S. Pat. No. 6,080,092 describes an industrial sponge roller device with a cylindrical body of polyvinyl acetal material and a plurality of projections of a truncated conical shape extending from an outer surface of the cylindrical body. Conventional synthetic sponges have a polymer structure with "dead end pockets" formed therein that trap residue and trace amounts of metals and have non-uniform pore sizes causing fluid backup and residue deposit. As the sponge wears, these metals can come out of the sponge in the form of particulate matter. Such particulate matter can damage the surfaces that are to be cleaned. Further, this type of sponge has tiny fibrils in the pores thereof that are a result of spaces between the pore forming chemical additive during a cross-linking reaction. "Cross-linking" is the formation of ester bonding between chains of the two adjacent hydroxyl groups that occur with the reaction of polyvinyl alcohol and aldehyde. This reaction hardens and strengthens the resulting material. US 2006/276108A1 to Benson describes a device that has a core and a sleeve made of the same plastic material by casting the sleeve material on the core layer to create a monolithic structure. Moreover, Benson describes that the sleeve may have nodules of 5-15 mm. Benson does not disclose a brush having a microporous core and a sleeve made of woven or knitted fabric with protruding freestanding fibers or fiber loops. The brush of Benson suffers from inconsistent surface contact with the cleaning surface and reduced cleaning efficiency.

The brushes therefore have material and structural inhomogeneity that is inherent to the manufacturing process. Non uniformity of material and pore structure creates non uniform contact between the brush and wafer, which translates to nonuniform contact force of cleaning. Additionally, total contact density of a flat surface is inherently limited. Typical PVA brushes have 4-10 mm diameter nodules on their surface, which perform actual cleaning. The contact area therefore reduces even further. It would be highly advantageous, therefore, to remedy the foregoing and other deficiencies inherent in the prior art.

### SUMMARY OF THE INVENTION

In view of the above, there is provided a new wafer cleaning brush design with controlled surface features and profile.

According to the invention, as defined in appended claim 1, there is provided a composite brush for semiconductor wafer cleaning. Accordingly, the brush comprises:
a microporous core having an inner surface and an outer surface; and
a sleeve securely positioned on the outer surface of the core,
wherein the inner surface of the core is configured to connect onto a mandrel of a wafer cleaning device,
wherein the sleeve comprises a woven or knitted fabric with a plurality of fiber loops extending above the outer surface of the sleeve.

The sleeve may comprise freestanding fibers and/or fiber loops extending in a direction forming an angle with the outer surface of the core of at least 45 degrees.

The freestanding fibers and or the fiber loops may extend in a direction normal or substantially normal to the brush surface.

The microporous core may be made of a microporous plastic material or composite plastic material comprising micro-channels and/or open pores allowing water to flow from the inner surface of the core through the core and out of the outer surface of the core into the sleeve.

The freestanding fibers and/or fiber loops may be 1 micron to 200 micron in diameter, preferably 1 to 100 microns in diameter, and more preferably 1 to 10 microns in diameter and extend 0.5 mm to 10 mm in height above the outer surface, preferably 1.0 mm to 7 mm in height above the outer surface of the sleeve, and more preferably 2.0 mm to 5.0 mm in height above the outer surface of the sleeve.

The fibers may be made of a single polymer or combination of polymers comprising polyester, nylon, polyurethanes, polyvinyl alcohol (PVA), polyvinyl acetate, or engineered fibers such as poly-para-phenylene terepthalamide, aromatic polyamid, polytetrafluoroethylene (PTFE), and ultra-high molecular weight polyethylene, preferably, polyester, nylon, and polyvinyl alcohol (PVA).

The fiber density of the base of the sleeve may be 1 per mm² to 2000 yarns per mm², preferably 25 per mm² to 1000 yarns per mm² , and more preferably 50 per mm² to 500 yarns per mm².

The freestanding fiber and/r fiber loop density is 1 per mm² to 2000 fibers and or fiber loops per mm², preferably 25 per mm² to 1000 yarns per mm², and more preferably 50 per mm² to 500 yarns per mm².

The sleeve surface contains may comprise both single freestanding fibers and fiber loops.

The sleeve surface may comprise fiber loops only.

The fibers and/or fiber loops may be arranged in a pattern including linear, circumferential, spiral, arc, nodular, or some other geometric pattern, preferably nodular or spiral.

The freestanding fibers and/or fiber loops may be formed together with the base of the sleeve on the surface of the sleeve in a single weaving or knitting process.

The core may be made of open cell microporous PVA, polyolefins such as polypropylene, polyurethane preferably polypropylene and PVA.

The core may be made of a melt-blown polypropylene filter cartridge.

The core may be made of a melt-blown nonwoven fibers made of a polyolefin, nylon, polyester or urethane.

In an embodiment the brush for post chemical/mechanical polishing cleaning of a semiconductor wafer may comprise:
a composite microporous core with open cell pores allowing water to pass through it; and
an outer sleeve disposed on the outer surface of the microporous core, the outer sleeve comprising a fabric made base and fiber loops on the fabric base and extending above the top surface of the sleeve,
wherein the brush has a first core flow resistance R1 through the microporous core, a second flow resistance through the base of the sleeve R2, and a third flow resistance R3 across the surface of the loops, and
wherein R3<R1<R2.

The fiber loops may be Terry fiber loops formed by weaving or knitting together with the base of the sleeve in a single process.

The sleeve weave density may be higher than a core brush density.

The core may have a pore percentage of from 60% to 90 % and the sleeve base may have a pore percentage of from 40% to 70 %.

These and other features and advantages of the invention will become apparent to those skilled in the art upon a review of the description of the presently preferred embodiments of the invention, viewed in conjunction with the appended drawings.

### BRIEF DESCRIPTION OF THE DRAWINGS

FIGS. 1(a) and 1(b) are simplified schematics of a conventional brush for wafer cleaning.
FIG. 2 (a) is a simplified schematic of a brush for wafer cleaning according to an embodiment of the present invention.
Fig 2(b) shows cross section of the brush of FIG. 2A.
Figure 3 shows a simplified enlarged view of a close-up of a fiber loop acting upon a particle defect on the surface of a wafer.
Figure 4 shows a top view of a conventional PVA brush with a plurality of nodules on its top surface.
Figure 5 shows a top view of the sleeve of the brush according to an embodiment of the present invention showing a nodular pattern formed by the fiber loops on the sleeve surface.

### DETAILED DESCRIPTION OF THE INVENTION

Various embodiments of the present disclosure are described below in more detail with reference to the accompanying drawings. We note, however, that the present invention may be embodied in different other embodiments, forms and variations thereof and should not be construed as being limited to the embodiments set forth herein. Rather, the invention and its preferred embodiments are defined in the appended set of claims and the described embodiments are provided so that this disclosure will be thorough and complete, and will fully convey the various aspects and features of the present invention to those skilled in the art to which this invention pertains. Throughout the disclosure, like reference numerals refer to like parts throughout the various figures and embodiments of the present invention.

The drawings are not necessarily to scale and, in some instances, proportions may have been exaggerated in order to clearly illustrate features of the embodiments.

It will be further understood that when an element is referred to as being "connected to", or "coupled to" another element, it may be directly on, connected to, or coupled to the other element, or one or more intervening elements may be present. In addition, it will also be understood that when an element is referred to as being "between" two elements, it may be the only element between the two elements, or one or more intervening elements may also be present.

It will be further understood that the terms "comprises," "comprising," "includes," and "including" when used in this specification, specify the presence of the stated elements and do not preclude the presence or addition of one or more other elements.

It is also noted, that in some instances, as would be apparent to those skilled in the relevant art, a feature or element described in connection with one embodiment may be used singly or in combination with other features or elements of another embodiment, unless otherwise specifically indicated.

Hereinafter, the various embodiments of the present invention will be described in detail with reference to the attached drawings.

According to a first embodiment, a brush comprises a microporous core having an inner and an outer surface. The inner surface may be attached to a mandrel which itself attaches to a cleaner device feeding deionized water into the brush through the mandrel. The inner surface may be configured to readily mount securely onto the mandrel. Various well-known designs may be used. The outer surface of the microporous core is attached to a sleeve containing a base made of fabric and freestanding fibers and or fiber loops. The base and freestanding fibers and or fiber loops may preferably be made of the same material.

The sleeve may be securely attached to the microporous core by any suitable means including, for example, sonic welding, thermal welding, stitching or other means to mechanically secure the connection. In an embodiment the sleeve may be connected to the core in a removably manner, for example, using one or more removable connectors, thus, allowing easy replacement of the sleeve after it has been used with a new sleeve.

The sleeve with the freestanding fibers and or the fiber loops is preferably formed by a weaving or knitting process and has a highly controlled height and spatial arrangement. In an embodiment several fibers may be combined to make the fiber or yarn used in the knitting or weaving of the fabric base and of the freestanding fibers and of fiber loops of the sleeve. The sleeve may comprise a porous base. The porous base may be made, for example, of the same material as the freestanding fibers and/or the fiber loops and preferably using the same weaving or knitting process. Unless specifically mentioned, yarn and fiber are used interchangeably without changing the meaning of the invention.

Traditional weaving process involves creating a fabric by interlacing fibers or yarn in an X-Y orientation. Several, long monofilament fibers or short length fibers may be processed to make the yarn for the weaving or knitting process. Individual fiber diameter and number of fibers combine to define thickness of yarn. Denier is a common term to classify yarn and is the weight in grams of 9000 meters of yarn length. A yarn of a desired denier may be formed by using several fine fibers or few coarser fibers. Highly precise weaving is used with one or more types of yarns to form various patterns and textures for the sleeve. Preferably, a weaving technique known as Terry may be used and which involves forming free standing loops across the whole surface of the fabric or in a predetermined pattern. The loops are formed on an outer side (top side or top surface) of the base of the sleeve that contacts the wafer. The loops thus formed can be left in closed form or cut to create free standing fibers. Due to their ability to flex, free standing loops or fibers allow for a more uniform contact and fluid transport at the wafer-brush interface than standard flat brush surface.

The loops can be arranged in a pattern, for example, in multiple circumferential rings with the number of the rings arranged across the length or in horizonal lines which span part or entire length of brush. Another example of a pattern is a spiral pattern. A spiral pattern arrangement provides a preferential direction motion along the diameter of the wafer. Loops could also be laid across the brush surface, in a geometric form such as grouped into squares of circles of a given size and pitch. The present invention composite brush design with the microporous core and the sleeve allows optimization of the cleaning efficiency and substantial reductions in DIW consumption.

The present invention allows for woven or knitted fiber loops patterns on the surface of the sleeve, i.e., a near limitless number of configurations for optimal layout and therefore cleaning efficiency. The diameter of the yarn is an important factor as the interaction between yarn and wafer debris is key to removal of particles and residues from the wafer surface. As the yarn diameter increases the stiffness of the loop increases and as the extension length of the loop increases, its flexibility and deflection increases. Mechanical properties of the fibers forming yarn also impact the stiffness and deflection. According to the present disclosure, brush construction can therefore be modulated with a combination of fiber material, individual fiber diameter and yarn diameter as well as loop extension and loop density.

According to an embodiment, the brush comprises a composite cylindrical shaped and microporous core with open cell pores forming microchannels through which the DIW flows from its inner surface to its outer surface. A sleeve is securely positioned on the outer surface of the core. The sleeve comprises a base made of fabric and fiber loops formed on the top (or outer surface) of the base. The brush has a first core flow resistance R1, a second through-surface flow resistance of the base of the sleeve R2, and a third flow resistance R3 across the surface of the loops, wherein R3<R1<R2. The flow resistance R1, R2, R3 describes water resistance per unit thickness in the direction of flow at a given water supply pressure. It is an indication of how easily does the water flow through the three sections of the composite brush, i.e., the core, the base of the sleeve, and the loops and or freestanding fibers.

In an embodiment, the microporous core may be made of polypropylene used in water filtration applications. Melt blown polypropylene filter cartridges are available in several pore sizes and are particularly suited for this application. Open cell, microporous PVA, urethane or a wound filament filter may also be used.

In an embodiment, the yarn loops may be Terry fiber loops formed by weaving or knitting. The surface weave density may be higher than a core brush density. The core may have a pore percentage from 60 to 90 % and a sleeve fabric surface may have a pore percentage of from 40 to 70 %. Higher or lower percentages maybe used, as long as, core porosity is higher than sleeve fabric porosity. In an embodiment the brush core may have a radius of 20 mm to 70 mm, the sleeve may have a thickness of 1-2 mm, and the yarn loops and or freestanding fibers may have a free-standing height of 2-5 mm.

The yarn may be made of polymer fibers made of at least one of polyester, nylon, polyurethanes, polyvinyl alcohol (PVA), polyvinyl acetate, or engineered fibers such as poly-para-phenylene terepthalamide, aromatic polyamid, polytetrafluoroethylene (PTFE), and ultra-high molecular weight polyethylene.

In a conventional brush the matrix material is constrained by larger matrix and near range connections to the matrix. By contrast according to the present disclosure, the individual nature of loops and fiber extension enables more efficient contact with particles and debris on the wafer. This individual nature of loops also enables efficient fluid distribution to and from every loop-wafer interface, thus improving cleaning efficiency. The invention thus provides an engineered surface design for the brush which exhibits improve cleaning efficiency by enabling fiber loops to clean the wafer surface. Improved contact dynamics leads to improved cleaning, while reducing DIW and cleaning chemical consumption.

The present disclosure employs the Terry textile process with specially engineered fibers for providing a PCMP brush with significantly enhanced cleaning performance and reduced DIW use. The Terry process enables high resolution, and highly tunable wafer contact, thus, significantly enhancing the cleaning ability of the PCMP brush for semiconductor wafers. Engineered fiber material and fiber diameter may be used to modulate the flexing response and design parameters like the size and surface density of loops for optimizing the cleaning performance. Additionally, such surface enables more efficient distribution of DIW and chemicals onto the wafer surface. It is understood that Terry is one method for creating surface texture by weaving or knitting. There are other weaving/knitting patterns that may also be used to generate the 3D fiber loop or freestanding fiber structures useful for the application. An advantage of the PCMP brush of the present disclosure is that it provides significant reduction in DIW usage compared to existing PCMP brushes.

The present disclosure enables decoupling pore percentage/pore size from compressibility thereby enabling lower water usage while enabling improved cleaning efficiency.

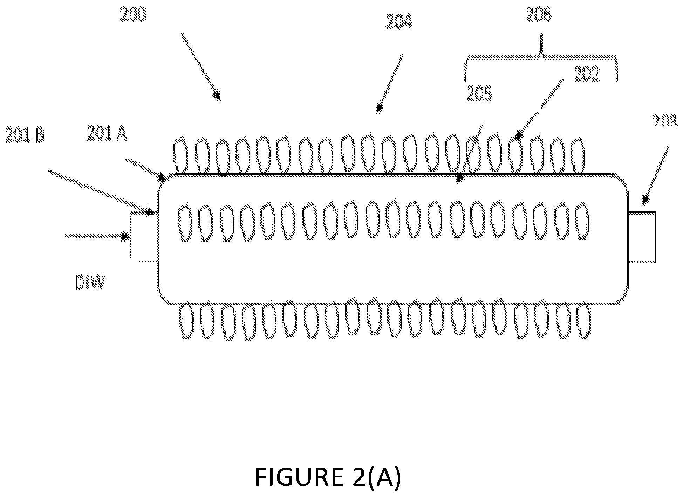

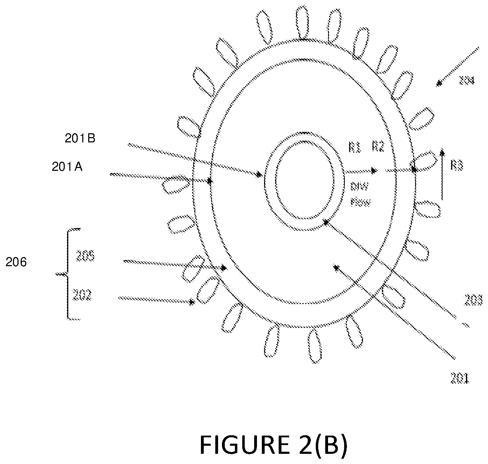

FIG. 2(A) is a simplified schematic of a brush according to an embodiment of the present invention. Fig 2(B) shows a cross section of the same. Referring now to FIGS. 2(A) and 2(B) a brush generally designated with numeral 200 is provided according to the present invention. The brush 200 includes a core 201 having a cylindrical shape an inner surface 201B and an outer surface 201A. The core 201 is mounted with its inner surface 201B onto a mandrel 203.

The brush 200 further comprises a fabric made (made form textile fibers) sleeve 206 with a sleeve base 205 and fiber loops 202 on the base 205. The sleeve 206 is securely attached to the outer surface of the core 201 while additional DIW spray 204 is applied during cleaning. In operation, DIW provided by the mandrel 203 flows through the open pores/micro-channels of the core into the base of the sleeve and out of the sleeve onto the loops and onto the wafer surface which is being cleaned. Additional DIW spray 204 may also be sprayed during cleaning.

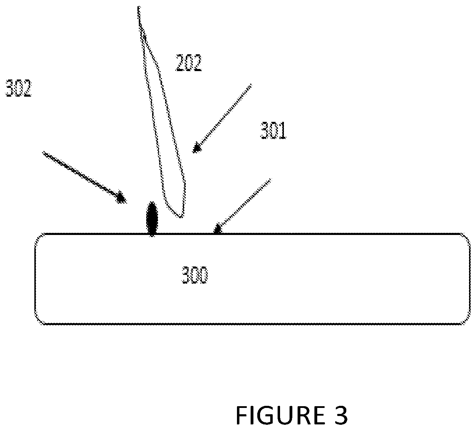

Figure 3 shows a close-up of a fiber loop 202 acting upon a particle defect 302 on the surface 301 of a wafer 300. The present invention brush allows a synergistic effect between the water action and the fiber loop action for cleaning any defects and/or impurities from the surface of the wafer, thus allowing substantial savings in water usage without compromising the effectiveness of the cleaning.

As conventional brush is made of homogeneous material composition, flow resistance in the brush core, surface and nodules is the same R1. The present invention PCMP brush has a core flow resistance of R1, a flow resistance at brush surface R2 and a flow resistance through surface R3 which are different, and preferably, for optimal performance R3 is less than R1, and R1 is less than R2, i.e., R3<R1<R2. Flow resistance R2 can be tuned by the density of the fiber weave/knitting. A dense weave results in higher pressure drop, while a light weave results in lower pressure drop. Pressure drop at the surface is important since it impacts a backflow of the cleaning particles. Higher pressure drop minimizes potential for backflow of the cleaning particles. Additionally having a lower surface fluid flow resistance of the cleaning fiber loops R3 also preferentially directs the flow across the brush surface. A surface weave density higher than the core brush density is desirable in controlling R2. In an embodiment the pore percentage of brush core is from 70 to 90% while the pore percentage of sleeve fabric surface is from 50 to 70%.

Higher or lower pore percentages maybe used as long as core porosity is higher than porosity of the sleeve surface. The material and design of fibers used to construct the fiber loops has an impact on cleaning efficiency. Flexing force imparted by yarn maybe modulated through fiber material properties, fiber and yarn diameter as well as free extension of loops above the surface. Suitable materials for the fibers include polymer fibers including polyester, nylon, polyurethanes, polyvinyl alcohol, polyvinyl acetate as well as engineered fibers such as poly-para-phenylene terepthalamide traded under the name Kevlar^{®} by Dupont, aromatic polyamid (also known as aramid), polytetrafluoroethylene (PTFE) traded under the name Teflon^{®} by DuPont, ultra-high molecular weight polyethylene (UHMWPE) and the like. Fiber material may be chosen such that, while some softening from water absorption may be desirable, properties are not significantly impacted by prolonged exposure to water and cleaning chemicals. It is desirable to use yarn with smaller diameter. Preferably yarn diameter may be 200 microns or less and more preferably microfibers may be used having diameter of less than 10 microns. The extension of the fiber loops or of the fibers above the free surface impacts their stiffness with shorter extension loops or fibers exhibiting higher stiffness than longer extension. Efficient wafer cleaning requires good, uniform contact between wafer and brush surface. Brush surface flatness is a function of the uniformity of microporous core and outer woven sleeve. As the gap between wafer and brush is reduced increasing number of loops contact the wafer surface until substantially all loops are touching the wafer surface. Overall surface height of loops needs to be controlled to allow uniform contact with minimal loop compression. The gap can then be adjusted to tune cleaning pressure. In an embodiment, loops having a nominal extension in the range of 1-5 mm maybe employed.

### Examples

### Sleeve

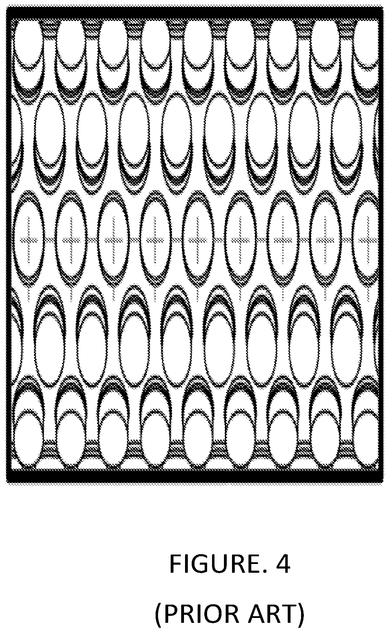

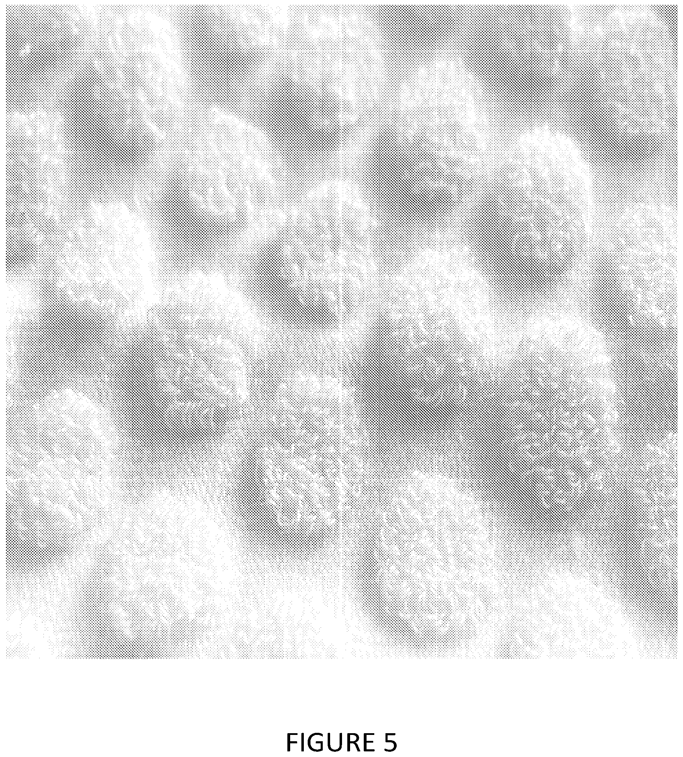

Example 1: In one embodiment the sleeve was made with yarn made of 30 polyester fibers each having diameter of app 5 microns. Sleeve base had fiber density of app 50/mm² and loop density of 50/mm². The loop height was 4 mm. A top view of the sleeve with the nodular pattern is shown in Figure 5. The individual nodules are made of a cluster of fiber loops. This is to be contrasted with the nodules of Figure 4 which shows a simplified schematic of a conventional PVA brush with plurality of PVA nodules on its surface. The nodules of Figure 4 have a diameter of 10 mm and are 5 mm high.

Example 2: In another embodiment sleeve was made with yarn made of 30 polyester fibers each having diameter of app 5 microns. Sleeve base had fiber density of app 50/mm2. Loops were arranged in 10 mm nodule rings at a pitch of 15 mm. The loop density in the nodules was 50/mm2 which when averaged for the entire brush surface was 12.5/mm2. The loop height was maintained at 4mm.

### Examples of the composite brush

### Examples 3 and 4

The sleeves of the Examples 1 and 2 were securely attached on the outer surface of a polypropylene filter model AVS20M20 made by Parker Inc. The filter cartridge has a length of 20 inches and diameter of 2.5 inches, element rated for 20 microns particulate removal. The filter cartridge was cut to match 218 mm length required to fit Ontrak Synergy wafer cleaner, made by Lam Corporation. Filter diameter of 2.5 inches diameter cylindrical and 5mm loop height match final brush diameter spec of 72 mm.

### Examples 5 and 6

The sleeves of examples 1 and 2 were securely attached on the outer surface of a filter cartridge model SP-P25-20 of SpiroPure Inc. which is 20 inches long and 2.5 inches in diameter for 25-micron particulate removal.

### Examples 7 and 8

The sleeves of examples 1 and 2 were securely attached on the outer surface of filter cartridge model SP-P50-20 of SpiroPure Inc. which had the same dimensions as the SP-P25-20 model and was rated for 50-micron particulates.

Substantial improvements in cleaning efficiency and reduction in water consumption were obtained with the brushes of examples 3 to 8 compared to a conventional PVA brush with nodules as the one illustrated in Figure 4.

## Claims

1. A composite, cylindrical brush (200) for semiconductor wafer cleaning, the brush comprising:
a microporous core (201) having an inner surface (201B) and an outer surface (201A); and a sleeve (206) securely positioned on the outer surface of the core,
wherein the inner surface of the core is configured to connect onto a mandrel (203) of a wafer cleaning device,
**characterised in that**
the sleeve (206) comprises a woven or knitted fabric with a plurality of fiber loops (202), and
wherein the fiber loops are extending above the outer surface of the sleeve.

2. The brush of claim 1,
wherein the fiber loops (202) are extending in a direction forming an angle with the outer surface of the core of at least 45 degrees, or
wherein the fiber loops (202) are extending in a direction normal or substantially normal to the brush surface.

3. The brush of any of the claims 1 or 2,
wherein the microporous core (202) is made of a microporous plastic material or a composite plastic material comprising micro-channels and/or open pores allowing water to flow from the inner surface of the core through the core and out of the outer surface of the core into the sleeve (206).

4. The brush of any of the claims 1 to 3, wherein the fiber loops (202) are 1 micron to 200 micron in diameter, preferably 1 to 100 microns in diameter, and more preferably 1 to 10 microns in diameter and extend 0.5 mm to 10 mm in height above the outer surface of the sleeve, preferably 1.0 mm to 7 mm in height
above the outer surface of the sleeve, and more preferably 2.0 mm to 5.0 mm in height above the outer surface of the sleeve.

5. The brush of any of the claims 1 to 4, wherein the fiber loops (202) are made of fibers made of a single polymer or a combination of polymers comprising polyester, nylon, polyurethanes, polyvinyl alcohol (PVA), polyvinyl acetate, or are engineered fibers such as poly-para-phenylene terepthalamide, aromatic polyamid, polytetrafluoroethylene (PTFE), and ultra-high molecular weight polyethylene, or are preferably, polyester, nylon, and polyvinyl alcohol (PVA).

6. The brush of any of the claims 1 to 5, wherein the sleeve (206) comprises a base (205) made of the woven or knitted fabric, and wherein the fiber density of the base (205) of the sleeve is 1 per mm² to 2000 yarns per mm², preferably 25 per mm² to 1000 yarns per mm², and more preferably 50 per mm² to 500 yarns per mm².

7. The brush of claim 1, wherein the fiber loop density is 1 per mm² to 2000 fibers and or fiber loops per mm², preferably 25 per mm² to 1000 yarns per mm², and more preferably 50 per mm² to 500 yarns per mm².

8. The brush of any of the claims 1 to 7,
wherein the sleeve surface further contains single freestanding fibers, or
wherein the sleeve surface contains fiber loops only.

9. The brush of any of the claims 1 to 8, wherein the fiber loops are arranged in a pattern including linear, circumferential, spiral, arc, nodular, or some other geometric pattern, preferably nodular or spiral, and are made of multifilament yarn.

10. The brush of claim 1,wherein the fiber loops are formed together with the base of the sleeve on the surface of the sleeve in a single weaving or knitting process, and
wherein the core is made of open cell microporous PVA, polyolefins such as polypropylene, polyurethane preferably polypropylene and PVA.

11. The brush of any of the claims 1 to 10,
wherein the core is made of a nonwoven polypropylene filter cartridge, or
wherein the core is a fabric made of a melt-blown polymer.

12. The brush of claim 3,
wherein the microporous core is made of a composite material with open cell pores,
wherein the woven or knitted fabric forms a base and the plurality of the fiber loops extending over the fabric made base, and
wherein the brush has a first core flow resistance R1 through the microporous core (201), a second flow resistance through the base (205) of the sleeve R2, and a third flow resistance R3 across the surface of the fiber loops (202), and
wherein R3<R1<R2.

13. The brush of claim 12, wherein the fiber loops are Terry fiber loops formed by weaving or knitting together with the base (205) of the sleeve in a single process.

14. The brush of any of the claims 12 or 13, wherein the core (201) has a higher porosity than the base (205) of the sleeve.

15. The brush of any of the claims 12 to 14,
wherein the core (201) has a pore percentage of from 60% to 90 % and the sleeve base (205) has a pore percentage of from 40% to 70 %, and
wherein the yarn fibers are polymer fibers made of at least one of polyester, nylon, polyurethanes, polyvinyl alcohol (PVA), polyvinyl acetate, or engineered fibers such as poly-para-phenylene terepthalamide, aromatic polyamid, polytetrafluoroethylene (PTFE), and ultra-high molecular weight polyethylene.

## Patentansprüche

1. Zylindrische Verbundbürste (200) zum Reinigen von Halbleiterscheiben, die Bürste aufweisend:
einen mikroporösen Kern (201) mit einer Innenfläche (201B) und einer Außenfläche (201A); und eine Hülse (206), die fest auf der Außenfläche des Kerns positioniert ist,
wobei die Innenfläche des Kerns so eingerichtet ist, dass sie sich mit einem Dorn (203) einer Scheibenreinigungsvorrichtung verbindet,
**dadurch gekennzeichnet, dass**
die Hülse (206) ein gewebtes oder gestricktes Gewebe mit einer Mehrzahl von Faserschleifen (202) aufweist, und
wobei sich die Faserschleifen über die Außenfläche der Hülse erstrecken.

2. Bürste nach Anspruch 1,
wobei sich die Faserschleifen (202) in einer Richtung erstrecken, einen Winkel mit der Außenfläche des Kerns von mindestens 45 Grad bildend, oder
wobei sich die Faserschleifen (202) in einer Richtung senkrecht oder im Wesentlichen senkrecht zu der Bürstenoberfläche erstrecken.

3. Bürste nach einem der Ansprüche 1 oder 2,
wobei der mikroporöse Kern (201) aus einem mikroporösen Kunststoffmaterial oder einem Kunststoffverbundmaterial hergestellt ist, das Mikrokanäle und/oder offene Poren aufweist, die es ermöglichen, dass Wasser von der Innenfläche des Kerns durch den Kern und aus der Außenfläche des Kerns in die Hülse (206) fließt.

4. Bürste nach einem der Ansprüche 1 bis 3, wobei die Faserschleifen (202) einen Durchmesser von 1 Mikrometer bis 200 Mikrometer, vorzugsweise einen Durchmesser von 1 bis 100 Mikrometer und besonders bevorzugt einen Durchmesser von 1 bis 10 Mikrometer aufweisen und sich in einer Höhe von 0,5 mm bis 10 mm über die Außenfläche der Hülse, vorzugsweise 1,0 mm bis 7 mm über die Außenfläche der Hülse und besonders bevorzugt 2,0 mm bis 5,0 mm über die Außenfläche der Hülse erstrecken.

5. Bürste nach einem der Ansprüche 1 bis 4, wobei die Faserschleifen (202) aus Fasern hergestellt sind, bestehend aus einem einzigen Polymer oder einer Kombination von Polymeren aufweisend Polyester, Nylon, Polyurethane, Polyvinylalkohol (PVA) und Polyvinylacetat, oder aus technischen Fasern bestehen, wie Poly-para-phenylenterephthalamid, aromatischem Polyamid, Polytetrafluorethylen (PTFE) und Polyethylen mit ultrahoher molarer Masse, oder vorzugsweise aus Polyester, Nylon und Polyvinylalkohol (PVA) bestehen.

6. Bürste nach einem der Ansprüche 1 bis 5, wobei die Hülse (206) eine Basis (205) aufweist, die aus dem gewebten oder gestrickten Gewebe hergestellt ist, und wobei die Faserdichte der Basis (205) der Hülse 1 pro mm² bis 2000 Garne pro mm², vorzugsweise 25 pro mm² bis 1000 Garne pro mm² und besonders bevorzugt 50 pro mm² bis 500 Garne pro mm² beträgt.

7. Bürste nach Anspruch 1, wobei die Faserschleifendichte 1 pro mm² bis 2000 Fasern und/oder Faserschleifen pro mm², vorzugsweise 25 pro mm² bis 1000 Garne pro mm² und besonders bevorzugt 50 pro mm² bis 500 Garne pro mm² beträgt.

8. Bürste nach einem der Ansprüche 1 bis 7,
wobei die Hülsenoberfläche ferner einzelne freistehende Fasern enthält, oder
wobei die Hülsenoberfläche nur Faserschleifen enthält.

9. Bürste nach einem der Ansprüche 1 bis 8, wobei die Faserschleifen in einem Muster, umfassend linear, umlaufend, spiralförmig, bogenförmig, knotenförmig oder ein anderes geometrisches Muster, vorzugsweise knotenförmig oder spiralförmig, angeordnet sind und aus Multifilamentgarn hergestellt sind.

10. Bürste nach Anspruch 1,
wobei die Faserschleifen zusammen mit der Basis der Hülse auf der Oberfläche der Hülse in einem einzigen Web- oder Strickvorgang gebildet werden, und
wobei der Kern aus offenzelligem mikroporösem PVA, Polyolefinen wie Polypropylen, Polyurethan, vorzugsweise Polypropylen und PVA, hergestellt ist.

11. Bürste nach einem der Ansprüche 1 bis 10,
wobei der Kern aus einer Vlies-Polypropylen-Filterkartusche hergestellt ist, oder
wobei der Kern ein Gewebe ist, das aus einem schmelzgeblasenen Polymer hergestellt ist.

12. Bürste nach Anspruch 3,
wobei der mikroporöse Kern aus einem Verbundmaterial mit offenzelligen Poren hergestellt ist,
wobei das gewebte oder gestrickte Gewebe eine Basis bildet und sich die Mehrzahl von Faserschlaufen über die gewebte Basis erstreckt, und
wobei die Bürste einen ersten Kernströmungswiderstand R1 durch den mikroporösen Kern (201), einen zweiten Strömungswiderstand R2 durch die Basis (205) der Hülse und einen dritten Strömungswiderstand R3 über die Oberfläche der Faserschleifen (202) hinweg aufweist, und
wobei R3 < R1 < R2.

13. Bürste nach Anspruch 12, wobei die Faserschleifen Frottee-Faserschleifen sind, die durch Weben oder Stricken zusammen mit der Basis (205) der Hülse in einem einzigen Verfahren gebildet sind.

14. Bürste nach einem der Ansprüche 12 oder 13, wobei der Kern (201) eine höhere Porosität als die Basis (205) der Hülse aufweist.

15. Bürste nach einem der Ansprüche 12 bis 14,
wobei der Kern (201) einen Porenprozentsatz von 60 % bis 90 % aufweist und die Hülsenbasis (205) einen Porenprozentsatz von 40 % bis 70 % aufweist, und
wobei die Garnfasern Polymerfasern sind, die aus mindestens einem von Polyester, Nylon, Polyurethanen, Polyvinylalkohol (PVA), Polyvinylacetat oder technischen Fasern wie Poly-para-phenylenterephthalamid, aromatischem Polyamid, Polytetrafluorethylen (PTFE) und Polyethylen mit ultrahohem Molekulargewicht, hergestellt sind.

## Revendications

1. Brosse cylindrique composite (200) pour le nettoyage de tranches de semi-conducteur, la brosse comprenant :
un noyau microporeux (201) ayant une surface interne (201B) et une surface externe (201A) ; et un manchon (206) solidement positionné sur la surface externe du noyau,
dans lequel la surface interne du noyau est configurée pour se raccorder à un mandrin (203) d'un dispositif de nettoyage de tranche,
**caractérisé en ce que**
le manchon (206) comprend un tissu tissé ou tricoté avec une pluralité de boucles de fibres (202), et
dans lequel les boucles de fibre s'étendent au-dessus de la surface externe du manchon.

2. Brosse selon la revendication 1,
dans lequel les boucles de fibres (202) s'étendent dans une direction formant un angle avec la surface externe du cœur d'au moins 45 degrés, ou
dans lequel les boucles de fibres (202) s'étendent dans une direction normale ou sensiblement normale à la surface de la brosse.

3. Brosse selon l'une quelconque des revendications 1 ou 2,
dans lequel le noyau microporeux (201) est fait d'un matériau plastique microporeux ou d'un matériau plastique composite comprenant des micro-canaux et/ou des pores ouverts permettant à l'eau de s'écouler depuis la surface interne du noyau à travers le noyau et hors de la surface externe du noyau dans le manchon (206).

4. Brosse selon l'une quelconque des revendications 1 à 3, dans laquelle les boucles de fibres (202) ont un diamètre de 1 µm à 200 µm, de préférence un diamètre de 1 à 100 µm, et de manière davantage préférée un diamètre de 1 à 10 µm, et s'étendent sur une hauteur de 0,5 mm à 10 mm au-dessus de la surface extérieure du manchon, de préférence une hauteur de 1,0 mm à 7 mm au-dessus de la surface extérieure du manchon, et de manière davantage préférée une hauteur de 2,0 mm à 5,0 mm au-dessus de la surface extérieure du manchon.

5. Brosse selon l'une quelconque des revendications 1 à 4, dans laquelle les boucles de fibres (202) sont faites de fibres faites d'un seul polymère ou d'une combinaison de polymères comprenant du polyester, du nylon, des polyuréthanes, de l'alcool polyvinylique (PVA), de l'acétate de polyvinyle, ou sont des fibres techniques telles que le poly-para-phénylène téréphtalamide, un polyamide aromatique, du polytétrafluoroéthylène (PTFE), et un polyéthylène à poids moléculaire ultra élevé, ou sont, de préférence, en polyester, en nylon et en alcool polyvinylique (PVA).

6. Brosse selon l'une quelconque des revendications 1 à 5, dans laquelle le manchon (206) comprend une base (205) faite du tissu tissé ou tricoté, et dans laquelle la densité de fibres de la base (205) du manchon est de 1 par mm² à 2000 fils par mm², de préférence de 25 par mm² à 1 000 fils par mm², et de manière davantage préférée de 50 par mm² à 500 fils par mm².

7. Brosse selon la revendication 1, dans laquelle la densité des boucles de fibres est de 1 par mm² à 2 000 fibres et/ou boucles de fibres par mm², de préférence de 25 par mm² à 1000 fils par mm², et plus préférablement de 50 par mm² à 500 fils par mm².

8. Brosse selon l'une quelconque des revendications 1 à 7,
dans lequel la surface du manchon contient en outre des fibres individuelles libres, ou
dans lequel la surface du manchon contient uniquement des boucles de fibres.

9. Brosse selon l'une quelconque des revendications 1 à 8, dans laquelle les boucles de fibres sont agencées selon un motif comprenant un motif linéaire, circonférentiel, en spirale, en arc, nodulaire, ou un autre motif géométrique, de préférence nodulaire ou en spirale, et sont réalisées en fil multifilament.

10. Brosse selon la revendication 1,
dans lequel les boucles de fibres sont formées avec la base du manchon sur la surface du manchon dans un processus de tissage ou de tricotage unique, et
dans lequel le noyau est fait de PVA microporeux à alvéoles ouvertes, de polyoléfines telles que le polypropylène, le polyuréthane, de préférence le polypropylène et le PVA.

11. Brosse selon l'une quelconque des revendications 1 à 10,
dans lequel le noyau est constitué d'une cartouche filtrante en polypropylène non tissé, ou
dans lequel le noyau est un tissu fait d'un polymère obtenu par soufflage à l'état fondu.

12. Brosse selon la revendication 3,
dans lequel le noyau microporeux est fait d'un matériau composite avec des pores à cellules ouvertes,
dans lequel le tissu tissé ou tricoté forme une base et la pluralité de boucles de fibres s'étendant au-dessus de la base en tissu, et
dans lequel la brosse a une première résistance à l'écoulement du noyau R1 à travers le noyau microporeux (201), une deuxième résistance à l'écoulement à travers la base (205) du manchon R2, et une troisième résistance à l'écoulement R3 à travers la surface des boucles de fibres (202), et
dans lequel R3<R1<R2.

13. Brosse selon la revendication 12, dans laquelle les boucles de fibres sont des boucles de fibres de Terry formées par tissage ou tricotage avec la base (205) du manchon en une seule opération.

14. Brosse selon l'une quelconque des revendications 12 ou 13, dans laquelle le noyau (201) a une porosité supérieure à celle de la base (205) du manchon.

15. Brosse selon l'une quelconque des revendications 12 à 14,
dans lequel le noyau (201) a un pourcentage de pores de 60 % à 90 % et la base de manchon (205) a un pourcentage de pores de 40 % à 70 %, et
dans lequel les fibres de fil sont des fibres polymères faites d'au moins un élément parmi le polyester, le nylon, les polyuréthanes, l'alcool polyvinylique (PVA), l'acétate de polyvinyle, ou des fibres modifiées telles que le poly-para-phénylène téréphtalamide, un polyamide aromatique, le polytétrafluoroéthylène (PTFE), et le polyéthylène de poids moléculaire ultra-élevé.
